(19) **Europäisches Patentamt / European Patent Office / Office européen des brevets**

(11) **EP 4 290 772 A1**

(12) # EUROPEAN PATENT APPLICATION

(43) Date of publication:
**13.12.2023 Bulletin 2023/50**

(21) Application number: **23177109.8**

(22) Date of filing: **02.06.2023**

(51) International Patent Classification (IPC):
**H03K 3/3565** $^{(2006.01)}$

(52) Cooperative Patent Classification (CPC):
**H03K 3/3565**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **06.06.2022 US 202263349176 P**
**31.05.2023 US 202318204374**

(71) Applicant: **MediaTek Inc.**
**Hsin-Chu 300 (TW)**

(72) Inventors:
• **TSAI, Chen-Han**
  **30078 Hsinchu City (TW)**
• **HSU, Chia-Hao**
  **30078 Hsinchu City (TW)**
• **ZENG, Zhi-Gang**
  **30078 Hsinchu City (TW)**
• **CHEN, Cheng-Tang**
  **30078 Hsinchu City (TW)**

(74) Representative: **Haseltine Lake Kempner LLP**
**Cheapside House**
**138 Cheapside**
**London EC2V 6BJ (GB)**

(54) **LOW POWER CLOCK BUFFER ARCHITECTURE**

(57)  The present invention provides a clock buffer (100), wherein the clock buffer receives an input signal (Vin) at a first node (N1) and generate an output signal (Vout) at a second node (N2). The clock buffer includes a P-type transistor (MP1), a first N-type transistor (Mn1), a resistor (R), a transistor (MN2) and a switch (MN3). A source electrode, a gate electrode and a drain electrode of the P-type transistor (MP1) are coupled to a supply voltage (Vdd), the first node (N1), and the second node (Vout), respectively. A gate electrode, a drain electrode and a source electrode of the first N-type transistor (MN1) are coupled to the first node (N1), the second node (N2) and a third node (n3), respectively. The resistor (R) is coupled between the first node and the second node. The transistor (MN2) is coupled between the first N-type transistor and a ground voltage. The switch (MN3) is configured to selectively connect the third node to the ground voltage.

FIG. 1

EP 4 290 772 A1

**Description**

This application claims the benefit of U.S. Provisional Application No. 63/349,176, filed on June 6th, 2022. The content of the application is incorporated herein by reference.

Background

A Schmitt trigger is a comparator circuit with hysteresis implemented by applying positive feedback to the noninverting input of a comparator or differential amplifier. However, since a supply voltage of the current chip is getting lower with the demand for power saving, a Schmitt trigger window also becomes smaller, and the circuit will suffer a noise rejection ability issue.

Summary

It is therefore an objective of the present invention to provide a clock buffer with hysteresis, which has a stable hysteresis window (Schmitt trigger window), to solve the above-mentioned problems.
According to one embodiment of the present invention, a clock buffer is disclosed, wherein the clock buffer receives an input signal at a first node and generates an output signal at a second node. The clock buffer comprises a P-type transistor, a first N-type transistor, a resistor, a transistor and a switch. A source electrode, a gate electrode and a drain electrode of the P-type transistor are coupled to a supply voltage, the first node, and the second node, respectively. A gate electrode, a drain electrode and a source electrode of the first N-type transistor are coupled to the first node, the second node and a third node, respectively. The resistor is coupled between the first node and the second node. The transistor is coupled between the first N-type transistor and a ground voltage, wherein a gate electrode of the transistor is coupled to the node N1. The switch is configured to selectively connect the third node to the ground voltage, or disconnect the third node from the ground voltage according to the output signal.
These and other objectives of the present invention will no doubt become obvious to those of ordinary skill in the art after reading the following detailed description of the preferred embodiment that is illustrated in the various figures and drawings.

Brief Description of the Drawings

        FIG. 1 is a clock buffer according to one embodiment of the present invention.
        FIG. 2 shows a relationship between an input signal and an output signal and a hysteresis window of the clock buffer according to one embodiment of the present invention.

Detailed Description

Certain terms are used throughout the following description and claims to refer to particular system components. As one skilled in the art will appreciate, manufacturers may refer to a component by different names. This document does not intend to distinguish between components that differ in name but not function. In the following discussion and in the claims, the terms "including" and "comprising" are used in an open-ended fashion, and thus should be interpreted to mean "including, but not limited to ...". The terms "couple" and "couples" are intended to mean either an indirect or a direct electrical connection. Thus, if a first device couples to a second device, that connection may be through a direct electrical connection, or through an indirect electrical connection via other devices and connections.

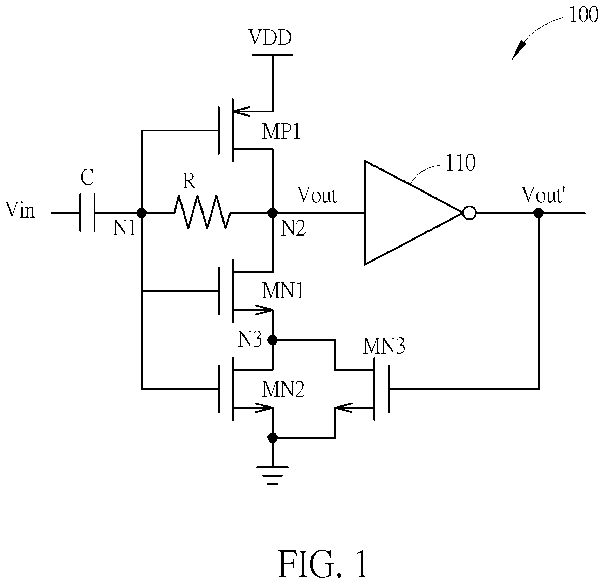

FIG. 1 is a clock buffer 100 according to one embodiment of the present invention. As shown in FIG. 1, the clock buffer 100 comprises a capacitor C, an inverter comprising aa P-type transistor MP1 and an N-type transistor MN1, a resistor R, an N-type transistor MN2, a switch (in this embodiment, an N-type transistor MN3 serves as the switch) and an inverter 110.
In the clock buffer 100, a source electrode of the P-type transistor MP1 is coupled to a supply voltage VDD, and a gate electrode and a drain electrode of the P-type transistor are coupled to a node N1 and a node N2, respectively. A gate electrode, a drain electrode and a source electrode of the N-type transistor MN1 are coupled to the node N1, the node N2 and a node N3, respectively. A gate electrode, a drain electrode and a source electrode of the N-type transistor MN2 are coupled to the node N1, the node N3 and a ground voltage, respectively. A drain electrode and a source electrode of the N-type transistor MN3 are coupled to the node N3 and the ground voltage. The resistor R1 is coupled between the node N1 and the node N2. An input signal (clock signal) Vin is inputted into the node N1 via a capacitor C, the inverter comprising the P-type transistor MP1 and the N-type transistor MN1 receives the input signal Vin from the node N1 to generate an output signal (clock signal) Vout at the node N2. The inverter 110 receives the output signal Vout to generate an inverted output signal Vout' to control the N-type transistor MN3.

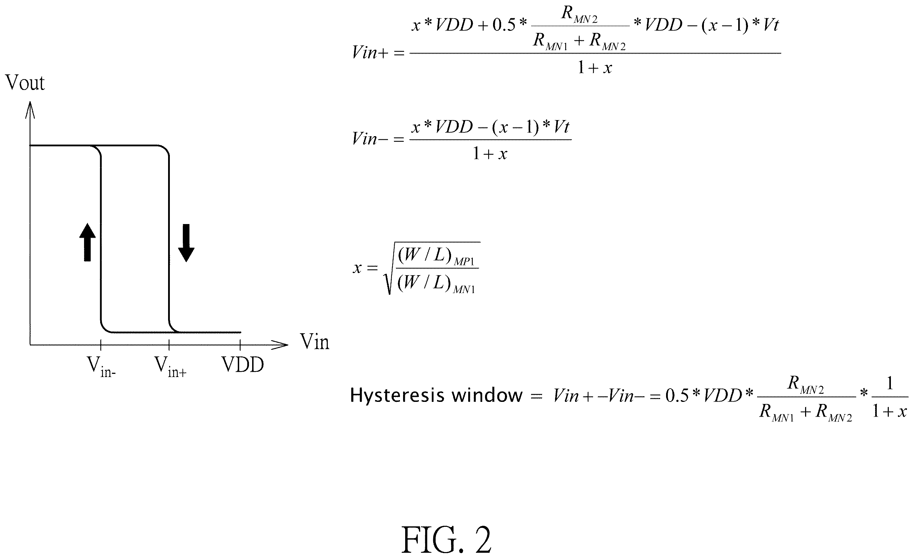

Refer to FIG. 2, which shows a relationship between the input signal Vin and the output signal Vout and a hysteresis window (Schmitt trigger window) of the clock buffer 100 according to one embodiment of the present invention. As shown in FIG. 2, when the input signal Vin is higher than a first threshold voltage Vin+, the output signal Vout has a low voltage level; when the input signal Vin is below a second threshold voltage Vin-, the output signal Vout has a high voltage level; and when the input signal Vin is between the first threshold voltage Vin+ and the second threshold voltage Vin-, the output signal Vout retains its level. In the circuit structure shown in FIG. 1, assuming that the P-type transistor and the N-type transistor have the same mobility and threshold voltage, the first threshold voltage Vin+ and the second threshold voltage Vin- can be obtained by using the following formula:

$$Vin+ = \frac{x*VDD + 0.5*\dfrac{R_{MN2}}{R_{MN1} + R_{MN2}}*VDD - (x-1)*Vt}{1+x} \quad \ldots\ldots\ldots\ldots\ldots\ldots\ldots\ldots (1);$$

$$Vin- = \frac{x*VDD - (x-1)*Vt}{1+x} \quad \ldots\ldots\ldots\ldots\ldots\ldots\ldots\ldots\ldots\ldots\ldots (2);$$

wherein $x = \sqrt{\dfrac{(W/L)_{MP1}}{(W/L)_{MN1}}}$ , "$R_{MN1}$" is an equivalent resistance of the N-type transistor MN1, "$R_{MN2}$" is an equivalent resistance of the N-type transistor MN2, "Vt" is the threshold voltage of the P-type transistor and N-type transistors shown in FIG. 1, $(W/L)_{MN1}$ is a size of the N-type transistor MN1 (i.e. a ratio between a channel width and a channel length), and $(W/L)_{MP1}$ is a size of the P-type transistor MP1 (i.e. a ratio between a channel width and a channel length).

The hysteresis window is a difference between the first threshold voltage Vin+ and the second threshold voltage Vin-, so the hysteresis window can be represented as the following formula:

$$Vin+ - Vin- = 0.5*VDD*\frac{R_{MN2}}{R_{MN1} + R_{MN2}}*\frac{1}{1+x} \quad \ldots\ldots\ldots\ldots\ldots\ldots\ldots\ldots (3).$$

In the formula (3), because "$R_{MN2}/ (R_{MN1}+R_{MN2})$" are relatively unaffected by process-voltage-temperature (PVT) variation, the hysteresis window of the clock buffer 100 is robust to the PVT variation. For example, because the N-type transistors MN1 and MN2 are the same type of transistors, if the actual equivalent resistance RMN2 the transistor N-type transistor MN2 is about 10% more than the design value, the actual equivalent resistance RMN1 the transistor N-type transistor MN1 should also be about 10% more than the design value, so "$R_{MN2}/ (R_{MN1}+R_{MN2})$" will not change too much due to the PVT variation, and the clock buffer 100 has a stable and predictable hysteresis window.

In the embodiment shown in FIG. 1, because a DC voltage of the input signal Vin may worsen the operations of the following circuits, so the capacitor C serves as a DC blocking circuit to block the DC voltage of the input signal Vin. In another embodiment, the capacitor C can be replaced by any other suitable DC blocking circuit. In yet another embodiment, if the DC voltage of the input signal Vin will not affect the operation of the clock buffer 100, the capacitor C can be removed from the clock buffer 100 shown in FIG. 1.

In addition, because the output signal Vout may not have a full swing, the inverter 110 is configured to receive the output signal Vout to generate the inverted output signal Vout' with a full swing (i.e. from supply voltage VDD to ground voltage). In another embodiment, the inverter 110 can be removed from the clock buffer 100, and the N-type transistor MN3 can be directly controlled by the output signal Vout, and the N-type transistor MN3 is replaced by another type of switch for selectively connecting the node N3 to the ground voltage when the output signal Vout has a low voltage level, and disconnecting the node N3 from the ground voltage when the output signal Vout has a high voltage level.

Briefly summarized, in the clock buffer of the present invention, by designing the transistor MN2 coupled between the N-type transistor MN1 and the ground voltage, the clock buffer 100 has a stable and predictable hysteresis window even if suffering worse process-voltage-temperature corner. Therefore, the clock buffer 100 has a stable and predictable hysteresis window, and the phases noise is reduced.

Those skilled in the art will readily observe that numerous modifications and alterations of the device and method may be made while retaining the teachings of the invention. Accordingly, the above disclosure should be construed as limited only by the metes and bounds of the appended claims.

## Claims

1. A clock buffer (100), wherein the clock buffer (100) receives an input signal at a first node and generates an output signal at a second node, and the clock buffer (100) comprises:

   a P-type transistor, wherein a source electrode, a gate electrode and a drain electrode of the P-type transistor are coupled to a supply voltage, the first node, and the second node, respectively;
   a first N-type transistor, wherein a gate electrode, a drain electrode and a source electrode of the first N-type transistor are coupled to the first node, the second node and a third node, respectively;
   a resistor, coupled between the first node and the second node;
   a transistor, coupled between the first N-type transistor and a ground voltage, wherein a gate electrode of the transistor is coupled to the node N1; and
   a switch, configured to selectively connect the third node to the ground voltage, or disconnect the third node from the ground voltage according to the output signal.

2. The clock buffer (100) of claim 1, wherein the transistor is a second N-type transistor, and a drain electrode and a source electrode of the second N-type transistor is coupled to the third node and the ground voltage, respectively.

3. The clock buffer (100) of claim 1, wherein the switch is a third N-type transistor, and a drain electrode and a source electrode of the third N-type transistor is coupled to the third node and the ground voltage, respectively.

4. The clock buffer (100) of claim 3, wherein a gate electrode of the third N-type transistor receives the output signal to connect the third node to the ground voltage, or disconnect the third node from the ground voltage according to the output signal.

5. The clock buffer (100) of claim 1, further comprising:
   a DC blocking circuit, wherein the input signal is inputted to the first node via the DC block circuit.

6. The clock buffer (100) of claim 5, wherein the DC blocking circuit is a capacitor.

7. The clock buffer (100) of claim 1, further comprising:

   an inverter (110), coupled to second node, configured to receive the output signal to generate an inverted output signal;
   wherein the switch is configured to selectively connect the third node to the ground voltage, or disconnect the third node from the ground voltage according to the inverted output signal.

8. The clock buffer (100) of claim 7, wherein the switch is a third N-type transistor, a gate electrode of the third N-type transistor receives the inverted output signal, and a drain electrode and a source electrode of the third N-type transistor is coupled to the third node and the ground voltage, respectively.

FIG. 1

$$Vin+ = \frac{x*VDD + 0.5*\dfrac{R_{MN2}}{R_{MN1}+R_{MN2}}*VDD - (x-1)*Vt}{1+x}$$

$$Vin- = \frac{x*VDD - (x-1)*Vt}{1+x}$$

$$x = \sqrt{\frac{(W/L)_{MP1}}{(W/L)_{MN1}}}$$

$$\text{Hysteresis window} = Vin+ - Vin- = 0.5*VDD*\frac{R_{MN2}}{R_{MN1}+R_{MN2}}*\frac{1}{1+x}$$

FIG. 2

Europäisches
Patentamt

European
Patent Office

Office européen
des brevets

# EUROPEAN SEARCH REPORT

Application Number

**EP 23 17 7109**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | DEHLAGHI BEHZAD ET AL: "A 0.3 pJ/bit 20 Gb/s/Wire Parallel Interface for Die-to-Die Communication", IEEE JOURNAL OF SOLID-STATE CIRCUITS, IEEE, USA, vol. 51, no. 11, 1 November 2016 (2016-11-01), pages 2690-2701, XP011626617, ISSN: 0018-9200, DOI: 10.1109/JSSC.2016.2596773 [retrieved on 2016-10-24] | 1-3,5-7 | INV. H03K3/3565 |
| A | * abstract; figures 5,10a,10b,10d * * page 2695, paragraph B * | 4,8 | |
| X | CN 108 667 440 A (FORTIOR TECH CO LTD) 16 October 2018 (2018-10-16) | 1-4,7,8 | |
| A | * figures 3,4 * | 5,6 | |
| A | WO 2020/006990 A1 (SHENZHEN GOODIX TECH CO LTD [CN]) 9 January 2020 (2020-01-09) * abstract; figures 3,4,5a,6 * * paragraphs [0026] - [0029], [0031], [0033], [0034] * | 1,5,6 | |

TECHNICAL FIELDS SEARCHED (IPC)

H03K

The present search report has been drawn up for all claims

| Place of search | Date of completion of the search | Examiner |
|---|---|---|
| Munich | 11 October 2023 | Mesic, Maté |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 17 7109

This annex lists the patent family members relating to the patent documents cited in  the above-mentioned European search report.
The members are as contained in the European Patent Office EDP file on
The European Patent Office is in no way liable for these particulars which are merely given for the purpose of information.

11-10-2023

| Patent document cited in search report | Publication date | Patent family member(s) | | Publication date |
|---|---|---|---|---|
| CN 108667440 A | 16-10-2018 | NONE | | |
| WO 2020006990 A1 | 09-01-2020 | EP | 3818424 A1 | 12-05-2021 |
| | | US | 2020014351 A1 | 09-01-2020 |
| | | WO | 2020006990 A1 | 09-01-2020 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 63349176